Europäisches Patentamt

(19) European Patent Office

Office européen des brevets

(11) Publication number: **0 146 688**
**B1**

(12) **EUROPEAN PATENT SPECIFICATION**

(45) Date of publication of patent specification: 08.06.88

(21) Application number: **84109620.9**

(22) Date of filing: **13.08.84**

(51) Int. Cl.⁴: **H 01 L 23/52**

(54) **An integrated circuit with a fusible link structure.**

(30) Priority: **21.12.83 US 564439**

(43) Date of publication of application:
**03.07.85 Bulletin 85/27**

(45) Publication of the grant of the patent:
**08.06.88 Bulletin 88/23**

(84) Designated Contracting States:
**DE FR GB NL**

(56) References cited:
**US-A-4 135 295**
**US-A-4 209 894**

**PATENT ABSTRACTS OF JAPAN vol. 7, no. 243,
28th October 1983, page (E 207) (1388)**

(73) Proprietor: **Monolithic Memories, Inc.
2175 Mission College Blvd.
Santa Clara, CA 95050 (US)**

(72) Inventor: **Whitten, Ralph
1034 Valerian Way, nr. 1
Sunnyvale, CA 94086 (US)**

(74) Representative: **Frankland, Nigel Howard
FORRESTER & BOEHMERT Widenmayerstrasse
4/I
D-8000 München 22 (DE)**

Courier Press, Leamington Spa, England.

0 146 688

## Description

The present invention relates to an integrated circuit with a fusible link structure, and in particular to a field programmable, custom logic, integrated circuit, such as a programmable read-only memory (PROM) or a programmable array logic circuit incorporating a fusible link structure.

PROMs and programmable array logic circuits are programmable integrated circuit structures which employ a means which can be manipulated or otherwise modified to provide a predetermined arrangement of electrically interconnected circuit elements. For example, a PROM, prior to being programmed comprises a uniform array of identical memory cells. In programming the PROM, certain memory cells are modified so that upon reading the PROM, the modified cells provide one kind of output such as a logical "1" and the unmodified cells provide another kind of output such as a logical "O".

Similarly, a programmable array logic circuit, prior to being programmed, comprises a uniform array of circuit elements. In programming the array, electrical connections between certain ones of the circuit elements are either left intact or broken to thus provide a custom logic circuit. An example of a programmable array logic circuit referred to herein is the "PAL" programmable array logic circuit manufactured by Monolithic Memories, Inc., of Santa Clara, California, USA. "PAL" is a trademark of Monolithic Memories, Inc.

The present invention is most closely related to those prior proposed programmable integrated circuit structures which are programmed by destroying or otherwise interrogating electrical connections between certain circuit elements in the structure. Fusible links have been used previously as the electrical connections which are to be interrupted.

In general, a fusible link structure comprises a conductive member which is provided for electrically interconnecting a pair of circuit elements. It has been proposed to provide conductive members which form fusible links which comprise a material selected from a number of different types of materials having predetermined electrical characteristics, commonly called fuse blowing characteristics. When it is desired to interrupt or break the interconnection established by the fusible link, a current of selected magnitude and duration is passed through the conductive member. The conductive member, typically comprising a resistive element, is thus caused to melt, or otherwise disintegrate or fracture and thereby become an open circuit.

Up to the present time widespread use has been made of tungsten-titanium fuses. Such fuses have a very high melting point (typically 3300°C). Nichrome fuses have also been used, which have lower melting temperatures than tungsten-titanium fuses, but which suffer from being difficult to fabricate consistently. The nichrome fuses are also highly prone to chemical attack. Platinum silicide fusible links have also been made using various compositions of platinum and silicon. In the fabrication of the prior known platinum silicide fusible links, the fusible links were formed by sintering platinum and silicon into predefined platinum silicate fuse regions. The resulting fuses were often found to have a melting point as high as 1229°C. A relatively high current and voltage were required to "blow" the fuse. Moreover, it was found that the fuse blowing characteristics were often inconsistent and varied over an undesirably wide range of current and voltage. These undesirable characteristics are, at least in part, attributed to the deposition of nonhomogeneous, nonuniform compositions of silicide by the conventional methods used in the fabrication of the previously known silicide fuses, regardless of the type of silicide used. Thus problems exist for prior art platinum silicide fuses, prior art tungsten silicide fuses, etc.

In US—A—4135295 platinum silicide fusible links are formed by sintering sputtered platinum with the underlying polysilicon films in the fuse regions.

In Patent Abstracts of Japan, Volume 7, No. 243, 28th October 1983 (E-207) (1388) there is described a semi-conductor memory device including a fuse element which is formed on a film of silicon oxide. The silicon oxide under the fuse element inhibits the dispersion of heat. However, the Japanese specification provides the specific teaching concerning the precise composition of the fuse element 7.

In addition to the problems associated with the use of non-homogeneous and nonuniform silicide films in prior known silicide fuse structures, it has also been determined that silicide fuse structures as well as other types of fuse structures, e.g. titanium-tungsten and polycrystalline silicon fuse structures suffer from problems associated with excessive thermal gradients which develop in the fuse structures during blowing of the fuse due to the thermal characteristics of the material contiguous with the fuse.

According to one aspect of this invention there is provided an integrated circuit structure incorporating a fusible link, said integrated circuit structure comprising a substrate, a first layer of dielectric material on said surface of the substrate, and a film of a meltable conductive material deposited on said layer, said film of conductive material constituting the fusible link, characterised in that the film of conductive material comprises a sputtered film of platinum silicide comprising, by weight, approximately 23±2.3% silicon, the film being of uniform homogeneous composition. Preferably the said first layer is intended to prevent the transfer of heat from said film when the fuse is melted. The conductive film is usually so thin that it has resistive properties.

Preferably said first layer is at least $2 \times 10^{-7}$ m (2000Å) thick.

Advantageously said first layer is a composite layer consisting of a layer of silicon oxide at least $1 \times 10^{-7}$ m (1000Å) thick superposed by a layer of silicon nitride at least $1 \times 10^{-7}$ m (1000Å) thick.

In another embodiment said first layer of dielectric material comprises a layer of polyimide.

2

Advantageously the first layer of dielectric material has a thermal conductivity of less than 14 milliwatts/cm$^2$°C.

Preferably the film of silicide is sintered.

Advantageously electrical contacts are provided for the first said film of conductive material, said contacts each being constituted by a second film of electrically conductive material, there being a layer of electrically conductive material disposed between said second film and the first said film of said conductive material, the layer of electrically conductive material being in electrical contact with both said films for passing current therethrough, the material of the layer of electrically conductive material comprising a material which inhibits material from said second film from diffusing into the first film of conductive material.

Preferably the first said film of conductive material comprises a sintered film of silicide, the second film of electrically conductive material comprises aluminium, and said layer of electrically conductive material comprises an alloy of titanium and tungsten.

Conveniently said layer comprises an alloy of tungsten and titanium, there being approximately 10%, by weight of titanium.

Advantageously the said film of conductive material has a melting point of less than 1100°C.

According to another aspect of this invention, there is provided a method of making a fusible link structure in an integrated circuit comprising the steps of: sputtering a film of uniform homogeneous composition of an electrically conductive material comprising platinum silicide having, by weight, approximately 23±2.3% silicon onto a layer of dielectric material which is carried by a substrate; etching or otherwise removing portions of the sputtered film to provide a fusible element; providing a first layer of electrically conductive material above said fusible elements; and providing a second layer of electrically conductive material between said first layer and said fusible element, said second layer being such as to inhibit the material of said first layer from diffusing into said fusible element, and removing parts of said first and second layers so that the remaining regions of the layers constitute contacts for the fusible element.

Preferably the method comprises the step of sintering said sputtered film before said layer of electrically conductive material is provided.

In the preferred embodiment the relatively thick layer of material of low thermal conductivity is provided contiguous with the fuse for controlling the magnitude of thermal gradients in the dielectric and heat loss from the fuse.

The invention will normally be used when an integrated circuit is formed on a substrate comprising a silicon or other type of semiconductor material in which there is formed a plurality of active devices, such as memory cells of logic circuits. Typically the integrated circuit is prepared by depositing on the surface of semiconductor material a layer of silicon oxide, a composite layer of silicon nitride and silicon oxide, or other suitable dielectric, such as polyimide. Preferably the layer should exceed a thickness of $2 \times 10^{-7}$ m (2000Å) and have a low thermal conductivity, e.g., 14 milliwatts/cm$^2$°C. After the oxide layer is deposited, a blanket of silicide formed of platinum and silicon is sputtered onto the oxide layer. Of importance, sputtering provides a highly homogeneous film of platinum and silicon. Thereafter, conventional photolithography techniques, including the use of photoresist and photomarks, are used to delineate fuse regions or sites on the thick oxide. With such suitable masking, the fuses (each having two ends and being approximately twice as long as wide) are formed by etching the silicide, for example in a tetrofluoromethane and oxygen ($CF_4$ and $O_2$) plasma discharge. Etching is completed when the silicide is completely removed except where fuses are to be formed. After etching, the resist is removed from the fuse sites and the remaining silicide under the removed resist is sintered to attain its final resistivity, e.g., 180 µohm-cm. Electrical contact is then made to the two ends of each fuse by means of a sputter deposition of a titanium-tungsten (TiW) diffusion barrier layer and a layer of aluminum (Al) interconnect metal. The interconnects are subsequently defined by standard photolithography techniques. Meanwhile, the titanium-tungsten and aluminum layers are etched to provide a gap therein over each fuse site so that the titanium-tungsten and aluminum layers only contact each end of each fuse. The process is continued by means of a conventional deposition of a "dielectric" oxide layer over the aluminum which contacts each fuse through the gap. Typically, a second metal layer and a layer of passivation glass is then deposited completing the fabrication of the novel fuse structure of this invention.

Using the above described structure and method of fabrication, there has been achieved in the fabrication of a fusible link according to the present invention in comparison to prior art structures, a 60—70% reduction in fuse blowing current and a 10—15% reduction in fuse blowing voltage. Specifically, fuse blowing currents of approximately 15 to 20 ma and fuse blowing voltages of approximately 2.3 to 2.8 volts have been achieved compared to typical prior art fuse blowing currents of 55 to 60 ma and fuse blowing voltages of 3.0 volts. Importantly, the fuse structures of this invention can have surprisingly uniform fuse-blowing characteristics.

In order that the invention may be more readily understood and so that further features thereof may be appreciated, the invention will now be described by way of example with reference to the accompanying drawings in which:

Figure 1 is a partial plan view of a fusible link structure on the surface of a suitably prepared integrated circuit substrate body according to the present invention during an intermediate manufacturing step:

3

Figure 2 is a partial cross-sectional view taken along the lines 2—2 of Figure 1, on an enlarged scale when manufacture of the substrate is completed:

Figure 3 is a graph depicting the fusing current required as a function of thickness of the oxide underlying the fuse; and

Figure 4 is a graph depicting the melting point of a platinum-silicon composition as a function of percent silicon.

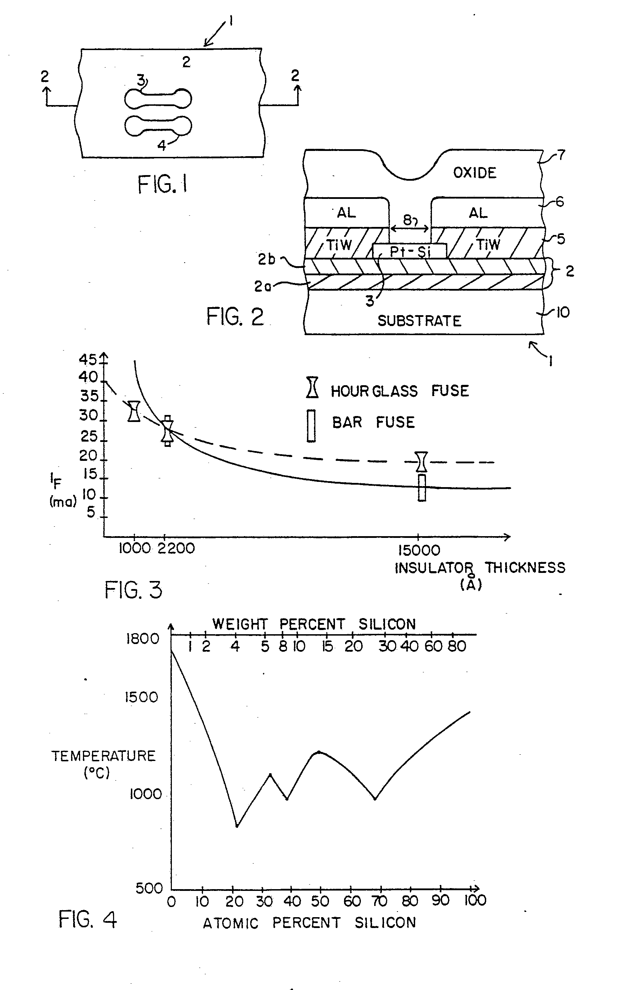

Referring to Figures 1 and 2, there is provided a suitably prepared integrated circuit designated generally as 1. The integrated circuit 1, of which only a very small portion is shown in Figure 1, typically comprises a silicon substrate 10 in which has been formed a plurality of active devices such as memory cells and/or logic circuits (not shown).

The surface of the substrate 10 has deposited or formed on it a thick layer 2 comprising a layer of silicon oxide superimposed by a thick composite layer of silicon nitride and silicon oxide or a thick layer of other suitable insulating material, such as polyimide. Preferably, layer 2 comprises a relatively thick layer 2a of thermally grown silicon oxide between 1000Å and 15000Å thick on which is deposited, for example by chemical vapour deposition, a layer 2b of silicon nitride, typically 1200Å thick. The thermal conductivity of layer 2 should be low, e.g. approximately 14 milliwatts/cm$^2$ °C or less.

After the layer 2 is formed on the substrate 10, a thin film 3 of an alloy of platinum and silicon comprising, by weight, approximately 23±2.3% silicon, is R.F. sputter deposited onto the surface of the layer 2. The sputtering is done using a target comprising a cold-pressed sintered powder composition of platinum and silicon, having the desired composition of approximately 23±2.3% silicon as described above, in an argon atmosphere using an R.F. signal having a frequency of about 13.56 MHz. Thereafter, using conventional photolithographic techniques and etching, for example plasma etching in a tetrofluoromethane atmosphere, individual discrete fusible links are formed on the layer 2. These fusible links can have any desired shape, although an hourglass shape or a rectangular bar shape are preferred. In one embodiment each hourglass shaped fuse was 11—14 μ long, 4—6 μ wide at its ends and about 1.5 μ wide in the middle. The fusible links 3 and 4 of substantially hourglass shape shown in Figures 1 and 2 illustrate typical fuses formed in accordance with this invention. After the etching step, the photoresist covering the fuse links is removed and the remaining silicide is sintered to attain a final resistivity of approximately 180 μohm-cm. The sintering is performed at 550°C for 10 minutes in a nitrogen atmosphere.

The final resistance of each fuse is in the range of 35 to 70 ohms. However, it is to be understood that this sintering step is not essential but, if not performed, the fuses will have higher resistivity and thus a greater programming voltage will be required to melt the fuses.

Electrical contact is then made to the opposite ends of each fusible link by a D.C. sputter deposition in an argon atmosphere of a titanium-tungsten (TiW) diffusion barrier layer 5 followed by a layer of aluminum or aluminum alloy 6. The TiW layer 5 typically comprises an alloy comprising 10% titanium and 90% tungsten, by weight, although these percentages are not considered to be critical. A typical thickness of the layer 5 is within the range of 1050 to 1350Å. The aluminum layer 6 is typically 7200Å to 8800Å thick.

The diffusion barrier 5 is disposed between the aluminum layer 6 and the fusible link 3 in order to prevent diffusion of the aluminum into the fusible link 3 which would change the resistance thereof. Of importance, the titanium-tungsten diffusion barrier 5 has a very high melting point and is very stable, and thus does not diffuse into the fusible link.

Following the deposition of the diffusion barrier 5 and the aluminum layer 6, the layers 5 and 6 are etched, for example using a hydrogen peroxide etch and a conventional metal etch, respectively. The etching of the layers 5 and 6 is done to provide a gap 8 therein of 4—7 microns wide over the centre of each fuse 3. After the layers 5 and 6 are etched, there is deposited, such as by chemical vapour deposition, a dielectric oxide layer 7 which is approximately 9000Å—10000Å thick. The dielectric layer 7 is provided to insulate the fusible link 3, the diffusion barrier 5 and the aluminum layer 6 from subsequently deposited conductive layers. After the deposition of the dielectric oxide layer 7, the integrated circuit is, if desired, subjected to additional conventional processing steps including, for example, forming a second metallization layer and a glass passivation layer (not shown). Vias (not shown) are provided through oxide layer 7 to connect conductive layers 5, 6 to current sources (not shown) in order to allow the fuse to be blown at the appropriate time, if desired. Vias are also necessary to connect the fuses to underlying active circuit elements.

A fusible link structure made in accordance with this invention as described above blows at a much lower current and voltage than do prior art fuses due to the greatly reduced melting point of the platinum-silicon eutectic used in the described fuses as compared with prior art fuse structures, and because the structure beneath the fuse minimizes heat flow away from the fuse 3 and thus reduces the power required to melt the fuse 3. Thus it has now been shown that it is desirable to provide a fuse having a low melting point. To minimize the heat flow away from the fuse 3, the thick dielectric layer 2 comprises a material having a relatively low thermal conductivity as described above. Figure 3 is a graph depicting the fusing current required to blow a fuse on an integrated circuit constructed in accordance with this invention as a function of the thickness of the dielectric beneath the fuse. The two lines in Figure 3 depict the characteristics of a hourglass shaped fuse and the characteristics of a rectangular fuse. The parameters of the fuses are as follows:

**0 146 688**

|  | | Hourglass | Rectangular |
|---|---|---|---|
| Material | | Platinum silicide, 23±2.3% silicon | Platinum silicide, 23±2.3% silicon |
| Fuse Length | | 5—6 microns | 4—5 microns |
| Fuse Width | | 1.5 microns (min, width) | 1.5 microns |
| Fuse Thickness | | 650Å | 650Å |

It is of importance to note that it is not essential in all cases to form thick dielectric layers on top of the fuse; any dielectric layer of convenient thickness can be used. The reason for this is that dielectric layers, such as silicon oxide or silicon nitride, have a higher thermal conductivity than the ambient atmosphere surrounding the integrated circuit. However, if metal interconnects are formed above the fuses, it is desired to have a relatively thick dielectric formed between the fuse and the metal interconnects to provide electrical insulation and to minimize heat dissipation from the fuse to the overlying metallization.

While the use of a thick oxide layer, such as layer 2, minimizes heat flow away from the fuse 3 due to low thermal conductivity of the oxide layer as compared to the thermal conductivity of the underlying substrate. It also, possibly even more importantly, reduces the thermal gradient driving force for the heat flow (that is, the magnitude of the thermal gradient decreases as the thickness of the layer 2 increases). Thus, layer 2 should preferably be as thick as possible in any given circuit regardless of the type of fuse with which it is used. Fuses suitable for use in accordance with this invention include, but are not limited to, titanium-tungsten, nickel-chromium (nichome), and polycrystalline silicon.

While fuses made from platinum-silicon alloys are known in the prior art, prior known methods of fabricating fuses have not provided fuses having a uniform, homogeneous composition as described above which are achieved due to the use of the process described above, which includes the formation of the fuses by sputtering. This uniformity and homogeneity is advantageous because it provides for very uniform fusing voltages and currents among fuses, die and wafers. Moreover, none of the prior known silicide fuses have used a platinum-silicon composition comprising 23±2.3% silicon. This composition was chosen as it provides a low melting point eutectic of 979°C.

In developing the above-described composition, it was found that the composition of the link 3 and the types of material used in making the link 3 are relatively critical. Only a small difference in the percentage of the component parts of the composition can result in a large variation in the melting piont of the composition, e.g., several hundred degrees centigrade. For example, a graphical representation of the melting point of a platinum-silicon composition as a function of percent silicon is shown in Figure 4.

While the ability to blow a fuse with low current and voltage is desirable in order to minimize power consumption, and to minimize circuit area by allowing the use of smaller access devices and electrical interconnections, and thereby increase reliability, possibly even more important is the ability to provide fuses having fuse blowing characteristics which are uniform and repeatable from fuse-to-fuse in any particular circuit structure, as well as in a number of circuit structures fabricated as separate integrated circuits.

**Claims**

1. An integrated circuit structure incorporating a fusible link, said integrated circuit structure comprising a substrate (10), a first layer (2) of dielectric material on the surface of said substrate, and a film (3) of a meltable conductive material deposited on said layer, said film of conductive material constituting the fusible link, characterised in that the film (3) of conductive material comprises a sputtered film of platinum silicide comprising, by weight, approximately 23±2.3% silicon, the film being of uniform homogeneous composition.

2. An integrated circuit structure according to claim 1, wherein said first layer (2) is at least $2 \times 10^{-7}$ m (2000Å) thick.

3. An integrated circuit structure according to claim 2, wherein said first layer (2) is a composite layer consisting of a layer of silicon oxide (2a) at least $1 \times 10^{-7}$ m (1000Å) superposed by a layer of silicon nitride (2b) at least $1 \times 10^{-7}$ m (1000Å) thick.

4. An integrated circuit structure according to claim 1 or claim 2, wherein the first layer (2) of dielectric material comprises a layer of polyimide.

5. An integrated circuit structure according to any one of the preceding claims wherein the first layer (2) of dielectric material has a thermal conductivity of less than 14 milliwatts/cm²°C.

6. An integrated circuit structure according to any one of the preceding claims wherein the film of silicide (3) is sintered.

7. An integrated circuit structure according to any one of the preceding claims, wherein electrical contacts are provided for the first said film (3) of conductive material, said contacts each being constituted by a second film (6) of electrically conductive material, there being a layer of electrically conductive

5

material (5) disposed between said second film (6) and the first said film (3) of said conductive material, the layer of electrically conductive material (5) being in electrical contact with both said films for passing current therethrough, the material of the layer of electrically conductive material comprising a material which inhibits material from said second film from diffusing into the first film of conductive material.

8. An integrated circuit structure according to claim 7, wherein the first said film (3) of conductive material comprises a sintered film of silicide, the second film of electrically conductive material comprises aluminium, (6) and said layer of electrically conductive material (5) comprises an alloy of titanium and tungsten.

9. An integrated circuit structure according to claim 7 or 8, wherein said layer (5) comprises an alloy of tungsten and titanium, there being approximately 10%, by weight, of titanium.

10. An integrated circuit structure according to any one of the preceding claims, wherein the said film (3) of conductive material has a melting point of less than 1100°C.

11. A method of making a fusible link structure in an integrated circuit comprising the steps of: sputtering a film (3) of uniform homogeneous composition of an electrically conductive material comprising platinum silicide having, by weight, approximately 23±2.3% silicon onto a layer (2) of dielectric material which is carried by a substrate (1); etching or otherwise removing portions of the sputtered film to provide a fusible element; providing a first layer of electrically conductive material (6) above said fusible element; and providing a second layer (5) of electrically conductive material between said first layer and said fusible element, said second layer being such as to inhibit the material of said first layer from diffusing into said fusible element, and removing parts of said first and second layers so that the remaining regions of the layers constitute contacts for the fusible element.

**Patentansprüche**

1. Integrierter Schaltkreisaufbau, der eine Sicherungsverbindung aufweist, wobei besagter integrierter Schaltkreisaufbau ein Substrat (10), eine erste Schicht (2) aus dielektrischem Material auf der Oberfläche besagten Substrats und einen Film (3) aus einem schmelzbaren Leitermaterial, der auf besagter Schicht abgeschieden ist, umfaßt, wobei besagter Film aus Leitermaterial die Sicherungsverbindung darstellt, dadurch gekennzeichnet, daß der Film (3) aus Leitermaterial einen durch Kathodenzerstäubung hergestellten Film aus Platinsilizid umfaßt, das annähernd 23±2,3 Gew.-% Silicium aufweist, wobei der Film von gleichmäßiger homogener Zusammensetzung ist.

2. Integrierter Schaltkreisaufbau nach Anspruch 1, dadurch gekennzeichnet, daß besagte erste Schicht (2) wenigstens $2×10^{-7}$ m (1000Å) dick ist.

3. Integrierter Schaltkreisaufbau nach Anspruch 2, dadurch gekennzeichnet, daß besagte erste Schicht (2) eine zusammengesetzte Schicht ist, die aus einer wenigstens $1×10^{-7}$ m (1000Å) dicken Schicht Siliciumoxid (2a) und einer diese überdeckenden, wenigstens $1×10^{-7}$ m (1000Å) dicken Schicht Siliciumnitrid (2b) besteht.

4. Integrierter Schaltkreisaufbau nach Anspruch 1 oder Anspruch 2, dadurch gekennzeichnet, daß besagte erste Schicht (2) aus dielektrischem Material eine Schichtaus Polyimid umfaßt.

5. Integrierter Schaltkreisaufbau nach einem der vorangehenden Ansprüche, dadurch gekennzeichnet, daß die ersten Schicht (2) aus dielektrischem Material eine Wärmeleitfähigkeit von weniger als 14 mW/cm$^{2}$°C besitzt.

6. Integrierter Schaltkreisaufbau nach einem der vorangehenden Ansprüche, dadurch gekennzeichnet, daß der Silicidfilm (3) gesintert ist.

7. Integrierter Schaltkreisaufbau nach einem der vorangehenden Ansprüche, dadurch gekennzeichnet, daß elektrische Kontakte für den ersten besagten Film (3) auf Leitermaterial vorgesehen sind, wobei jeder der besagten Kontakte von einem zweiten Film (6) aus elektrisch leitendem Material gebildet wird, wobei zwischen besagtem zweiten Film (6) und dem ersten besagten Film (3) aus besagtem Leitermaterial eine Schicht aus elektrisch leitendem Material (5) liegt, wobei die Schicht aus elektrisch leitendem Material (5) in elektrischem Kontakt mit beiden besagten Filmen steht, um Strom dort hindurch zu lassen, wobei das Material der Schicht aus elektrisch leitendem Material ein Material umfaßt, das es verhindert, daß Material aus besagtem zweiten Film in den ersten Film aus Leitermaterial diffundiert.

8. Integrierter Schaltkreisaufbau nach Anspruch 7, dadurch gekennzeichnet, daß der erste besagte Film (3) aus Leitermaterial einen gesinterten Film aus Silicid, der zweite Film aus elektrisch leitendem Material (6) Aluminium und besagte Schicht aus elektrisch leitendem Material (5) eine Legierung aus Titan und Wolfram umfaßt.

9. Integrierter Schaltkreisaufbau nach Anspruch 7 oder 8, dadurch gekennzeichnet, daß besagte Schicht (5) eine Legierung aus Wolfram und Titan umfaßt, wobei annähernd 10 Gew.-% -Titan vorliegen.

10. Integrierter Schaltkreisaufbau nach einem der vorangehenden Ansprüche, dadurch gekennzeichnet, daß der besagte Film (3) aus Leitermaterial einen Schmelzpunkt von weniger als 1100°C besitzt.

11. Verfahren zum Herstellen eines Sicherungsverbindungsaufbaus in einem integriertem Schaltkreis, gekennzeichnet durch folgende Schritte: Herstellen eines Films (3) von gleichmäßiger homogener Zusammensetzung aus einem elektrisch leitenden Material, das Platinsilicid mit annähernd 23±2,3 Gew.-% Silicium umfaßt, durch Kathodenzerstäubung auf einer Schicht (2) aus dielektrischem Material, das von einem Substrat (1) getragen wird; Ätzen oder andersartiges Entfernen von Teilen des durch Kathodenzerstäubung hergestellten Films, um ein Sicherungselement zu schaffen; Schaffen einer ersten Schicht aus elektrisch leitendem Material (6) über besagtem Sicherungselement; und Schaffen einer zweiten Schicht (5) aus elektrisch leitendem Material zwischen besagter erster Schicht und besagtem Sicherungselement, wobei besagte zweite Schicht so beschaffen ist, daß sie es verhindert, daß das Material der besagten ersten Schicht in besagtes Sicherungselement diffundiert, und Entfernen von Teilen der besagten ersten und zweiten Schicht, so daß die verbleibenden Bereiche der Schichten Kontakte für das Sicherungselement darstellen.

## Revendications

1. Structure de circuit intégré incorporant une liaison fusible, ladite structure de circuit intégré comprenant un substrat (10), une première couche (2) de matériau diélectrique disposée sur la surface dudit substrat, et une pellicule (3) d'un matériau conducteur pouvant fondre qui est déposée sur ladite couche, ladite pellicule de matériau conducteur constituant la liaison fusible, caractérisée en ce que que la pellicule (3) de matériau conducteur comprend une pellicule pulvérisée de siliciure de platine contenant, en poids, environ 23±2,3% de silicium, la pellicule ayant une composition uniforme homogène.

2. Structure de circuit intégré selon la revendication 1, ou ladite première couche (2) a une épaisseur d'au moins $2 \times 10^{-7}$ m (2000Å).

3. Structure de circuit intégré selon la revendication 2, où ladite première couche (2) est une couche composite constituée d'une couche d'oxyde de silicium (2a) d'une épaisseur d'au moins $1 \times 10^{-7}$ m (1000Å) à laquelle est superposée une couche de nitrure de silicium (2b) d'une épaisseur d'au moins $1 \times 10^{-7}$ m (1000Å).

4. Structure de circuit intégré selon la revendication 1 ou 2, où ladite première couche (2) de matériau diélectrique comprend une couche de polyimide.

5. Structure de circuit intégré selon l'une quelconque des revendications précédentes, où la première couche (2) de matériau diélectrique possède une conductivité thermique inférieure à 14 mW/cm² . °C).

6. Structure de circuit intégré selon l'une quelconque des revendications précédentes, où la pellicule de siliciure (3) est frittée.

7. Structure de circuit intégré selon l'une quelconque des revendications précédentes, où des contacts électriques sont prévus pour la première dite pellicule (3) de matériau conducteur, lesdits contacts étant chacun constitués par une deuxième pellicule (6) de matériau électriquement conducteur, une couche de matériau électriquement conducteur (5) étant disposés entre ladite deuxième pellicule (6) et la première dite pellicule (3) dudit matériau conducteur, la couche de matériau électriquement conducteur (5) étant en contact électrique avec les deux pellicules afin de laisser passer le courant, le matériau de la couche de matériau électriquement conducteur comprenant un matériau qui empêche du matériau de ladite deuxième pellicule de diffuser dans la première pellicule de matériau conducteur.

8. Structure de circuit intégré selon la revendication 7, où la première dite pellicule (3) de matériau conducteur comprend une pellicule frittée de siliciure, la deuxième pellicule de matériau électriquement conducteur comprend de l'aluminium (6), et ladite couche de matériau électriquement conducteur (5) comprend un alliage de titane et de tungstène.

9. Structure de circuit intégré selon la revendication 7 ou 8, où ladite couche (5) comprend un alliage de tungstène et de titane, le titane étant présent à raison d'environ 10% en poids.

10. Structure de circuit intégré selon l'une quelconque des revendications précédentes, où ladite pellicule (3) de matériau conducteur possède un point de fusion inférieur à 1100°C.

11. Procédé de fabrication d'une structure de liaison fusible dans un circuit intégré, comprenant les opérations suivantes: pulvériser une pellicule (3) de composition uniforme homogène d'un matériau électriquement conducteur qui comprend du siliciure de platine possédant, en poids, environ 23±2,3% de silicium, sur une couche (2) de matériau diélectrique qui est portée par un substrat (1); inciser, ou enlever d'une quelconque autre manière, des parties de la pellicule pulvérisée afin de produire un élément fusible; produire une première couche de matériau électriquement conducteur (6) au-dessus dudit élément fusible; et produire une deuxième couche (5) de matériau électriquement conducteur entre ladite première couche et ledit élément fusible, ladite deuxième couche étant telle qu'elle empêche le matériau de ladite première couche de diffuser dans ledit élément fusible, et retirer des parties desdites première et deuxième couches de façon que les parties restantes des couches constituent des contacts pour l'élément fusible.

FIG. 1

FIG. 2

FIG. 3

FIG. 4